# EUROPEAN PATENT APPLICATION

(11) **EP 3 933 944 A1**
(43) Date of publication of application: **05.01.2022**
(21) Application number: 20763741.4
(22) Date of filing: 15.01.2020
(51) Int. Cl.: H01L 33/62, G09F 9/00, G09F 9/30, G09F 9/33

(54) **MICRO-LED ELEMENT MOUNTED SUBSTRATE, AND DISPLAY DEVICE USING SAME**

(30) Priority: 26.02.2019 JP 2019032358
(71) Applicant: Kyocera Corporation, Kyoto-shi, Kyoto 612-8501 (JP)
(72) Inventor: ITO, Hiroaki, Kyoto-shi, Kyoto 612-8501 (JP); AOKI, Katsumi, Kyoto-shi, Kyoto 612-8501 (JP)
(74) Representative: TBK
(86) International application number: PCT/JP2020/001077
(87) International publication number: WO 2020/174909

(57) **Abstract**

A micro-light-emitting diode (LED) mounting board includes a substrate (1) having a mount surface (1a) receiving multiple micro-LEDs, and at least one pixel unit (15) located on the mount surface (1a) and including the multiple micro-LEDs (74R, 74G, 74B) having different emission colors to operate as a basic element of display. The multiple micro-LEDs (74R, 74G, 74B) include vertical stacks of multiple first electrodes (61R, 61G, 61B), multiple emissive layers (74RL, 74GL, 74BL), and multiple second electrodes (62R, 62G, 62B). The at least one pixel unit (15) includes a power electrode pad (60S) connected to each of the multiple second electrodes (62R, 62G, 62B). The power electrode pad (60S) is spaced from each of the multiple first electrodes (61R, 61G, 61B) by a distance (L1, L2, L3) greater than an interelectrode distance (L4, L5) between adjacent first electrodes of the multiple first electrodes (61R, 61G, 61B).

## Description

### FIELD

The present disclosure relates to a micro-light-emitting diode (LED) mounting board including micro-LEDs and to a display device including the micro-LED mounting board.

### BACKGROUND

A known light emitter board includes light emitters such as micro-light-emitting diodes (LEDs), and a known self-luminous display device that eliminates a backlight device includes the light emitter board. Such a display device is described in, for example, Patent Literature 1.

### CITATION LIST

### PATENT LITERATURE

Patent Literature 1: Japanese Unexamined Patent Application Publication (Translation of PCT Application) No. 2016-522585

### BRIEF SUMMARY

A micro-light-emitting diode mounting board according to an aspect of the present disclosure includes a substrate having a mount surface receiving a plurality of micro-light-emitting diodes (LEDs), and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes.

A micro-light-emitting diode mounting board according to another aspect of the present disclosure includes a substrate having a mount surface receiving a plurality of micro-LEDs, and a plurality of pixel units on the mount surface. Each of the plurality of pixel units includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The plurality of pixel units include a first pixel unit including a power electrode pad connected to each of the plurality of second electrodes in the plurality of micro-LEDs and a second pixel unit adjacent to the first pixel unit and free of the power electrode pad. The power electrode pad is spaced from each of the plurality of first electrodes in the first pixel unit by a distance greater than an interelectrode distance between adjacent first electrodes of the plurality of first electrodes in the first pixel unit. The power electrode pad is spaced, by a distance greater than an interelectrode distance between adjacent first electrodes of the plurality of first electrodes in the second pixel unit, from a first electrode in a micro-LED closest to the power electrode pad of the plurality of micro-LEDs included in the second pixel unit.

A display device according to another aspect of the present disclosure includes one of the above micro-light-emitting diode mounting boards. The substrate has an opposite surface opposite to the mount surface, and a side surface. The micro-light-emitting diode mounting board includes side wiring on the side surface and a driver on the opposite surface. The at least one pixel unit includes a plurality of pixel units arranged in a matrix. The plurality of micro-LEDs are connected to the driver with the side wiring.

A micro-light-emitting diode mounting board according to another aspect of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes. The power electrode pad is less optically sensible than each of the plurality of second electrodes in a visible light region.

A micro-light-emitting diode mounting board according to another aspect of the present disclosure includes a substrate having a mount surface receiving a plurality of micro-LEDs, and at least one pixel unit on the mount surface. The at least one pixel unit includes the plurality of micro-LEDs to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes.

A micro-light-emitting diode mounting board according to another aspect of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than or equal to an interelectrode distance between adjacent first electrodes of the plurality of first electrodes.

### BRIEF DESCRIPTION OF DRAWINGS

The objects, features, and advantages of the present disclosure will become apparent from the following detailed description and the drawings.
FIG. 1 is a plan view of one pixel unit included in a pixel area in a micro-light-emitting diode (LED) according to an embodiment of the present disclosure.
FIG. 2A is a plan view of two pixel units shown in FIG. 1 aligned laterally.
FIG. 2B is a plan view of two pixel units shown in FIG. 1 aligned vertically.
FIG. 3A is a plan view of two laterally aligned pixel units with a single power electrode pad in a micro-LED mounting board according to another embodiment of the present disclosure.
FIG. 3B is a plan view of two vertically aligned pixel units with a single power electrode pad in a micro-LED mounting board according to another embodiment of the present disclosure.
FIG. 4A is a plan view of a power electrode pad in an example shape included in a micro-LED mounting board according to another embodiment of the present disclosure.
FIG. 4B is a plan view of a power electrode pad in an example shape included in a micro-LED mounting board according to another embodiment of the present disclosure.
FIG. 4C is a plan view of a power electrode pad in an example shape included in a micro-LED mounting board according to another embodiment of the present disclosure.
FIG. 4D is a plan view of a power electrode pad in an example shape included in a micro-LED mounting board according to another embodiment of the present disclosure.
FIG. 4E is a plan view of a power electrode pad in an example shape included in a micro-LED mounting board according to another embodiment of the present disclosure.
FIG. 4F is a plan view of a power electrode pad in an example shape included in a micro-LED mounting board according to another embodiment of the present disclosure.
FIG. 4G is a plan view of a power electrode pad in an example shape included in a micro-LED mounting board according to another embodiment of the present disclosure.
FIG. 4H is a plan view of a power electrode pad in an example shape included in a micro-LED mounting board according to another embodiment of the present disclosure.
FIG. 5 is a cross-sectional view of a micro-LED mounting board according to another embodiment of the present disclosure, taken along line C1-C2 in FIG. 1 as viewed in the direction indicated by arrows.
FIG. 6 is a plan view of a driver and back wiring located on an opposite surface of a micro-LED mounting board according to another embodiment of the present disclosure.
FIG. 7 is a block circuit diagram of an example light-emitting device with the structure that forms the basis of a display device according to an embodiment of the present disclosure.
FIG. 8A is a cross-sectional view taken along line A1-A2 in FIG. 7.
FIG. 8B is an enlarged plan view of one pixel unit in FIG. 7.
FIG. 9A is an enlarged plan view of four pixel units included in a known display device including vertical micro-LEDs.
FIG. 9B is a cross-sectional view taken along line B1-B2 in FIG. 9A as viewed in the direction indicated by arrows.
FIG. 10 is a plan view of one pixel unit included in a pixel area in a micro-LED mounting board according to another embodiment of the present disclosure.

### DETAILED DESCRIPTION

A micro-light-emitting diode (LED) mounting board and a display device according to one or more embodiments of the present invention will now be described with reference to the drawings. Each figure referred to below shows main components and other elements of the micro-LED mounting board and the display device according to the embodiments. The micro-LED mounting board and the display device according to the embodiments may thus include known components not shown in the figures, such as circuit boards, wiring conductors, control integrated circuits (ICs), and large-scale integration (LSI) circuits.

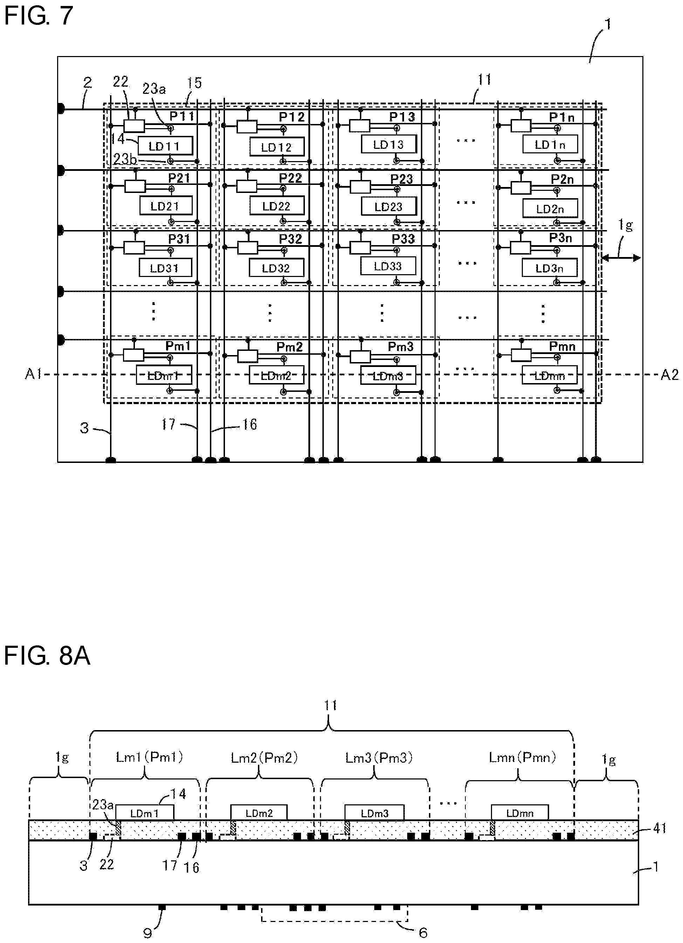

A display device with the structure that forms the basis of a display device according to one or more embodiments of the present disclosure will first be described with reference to FIGs. 7 to 9B.

The display device with the structure that forms the basis of the display device according to one or more embodiments of the present disclosure is a backlight-free, self-luminous display device including a light emitter board including light emitters such as micro-LEDs. The display device includes a glass substrate 1, scanning signal lines 2 extending in a predetermined direction (e.g., a row direction) on the glass substrate 1, emission control signal lines 3 crossing the scanning signal lines 2 and extending in a direction (e.g., a column direction) crossing the predetermined direction, an effective area (pixel area) 11 including multiple pixel units (Pmn) 15 defined by the scanning signal lines 2 and the emission control signal lines 3, and multiple light emitters 14 located on an insulating layer. The scanning signal lines 2 and the emission control signal lines 3 are connected to back wiring 9 on the back surface of the glass substrate 1 with side wiring on a side surface of the glass substrate 1. The back wiring 9 is connected to driving elements 6 such as ICs and LSI circuits mounted on the back surface of the glass substrate 1. In other words, the display in the display device is driven and controlled by the driving elements 6 on the back surface of the glass substrate 1. The driving elements 6 are mounted on the back surface of the glass substrate 1 by, for example, chip on glass (COG).

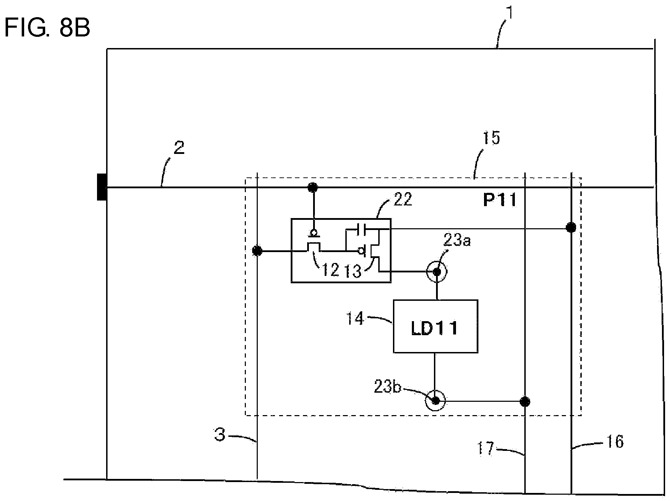

Each pixel unit (Pmn) 15 includes an emission controller 22 to control, for example, the emission or non-emission state and the light intensity of the light emitter (LDmn) 14 in an emissive area (Lmn). The emission controller 22 includes a thin-film transistor (TFT) 12 (shown in FIG. 8B) as a switch for inputting an emission signal into the light emitter 14 and a TFT 13 (shown in FIG. 8B) as a driving element for driving the light emitter 14 with a current using an electric potential difference (emission signal) between a positive voltage (anode voltage of about 3 to 5 V) and a negative voltage (a cathode voltage of about -3 to 0 V) corresponding to the level (voltage) of an emission control signal (a signal transmitted through the emission control signal lines 3). The connection line connecting the gate electrode and the source electrode of the TFT 13 receives a capacitor, which retains the voltage of the emission control signal input into the gate electrode of the TFT 13 until subsequent rewriting is performed (for a period of one frame).

The light emitter 14 is electrically connected to the emission controller 22, a positive voltage input line 16, and a negative voltage input line 17 with feedthrough conductors 23a and 23b such as through-holes formed through an insulating layer 41 (shown in FIG. 8A) located in the effective area 11. In other words, the positive electrode of the light emitter 14 is connected to the positive voltage input line 16 with the feedthrough conductor 23a and the emission controller 22, and the negative electrode of the light emitter 14 is connected to the negative voltage input line 17 with the feedthrough conductor 23b.

The display device also includes a frame 1g between the effective area 11 and the edge of the glass substrate 1 as viewed in plan. The frame 1g, which does not contribute to display, may receive an emission control signal line drive, a scanning signal line drive, and other components. The width of the frame 1g is to be minimized.

In another example, a light-emitting device includes multiple micro-LEDs located in a reflective bank structure as a subpixel.

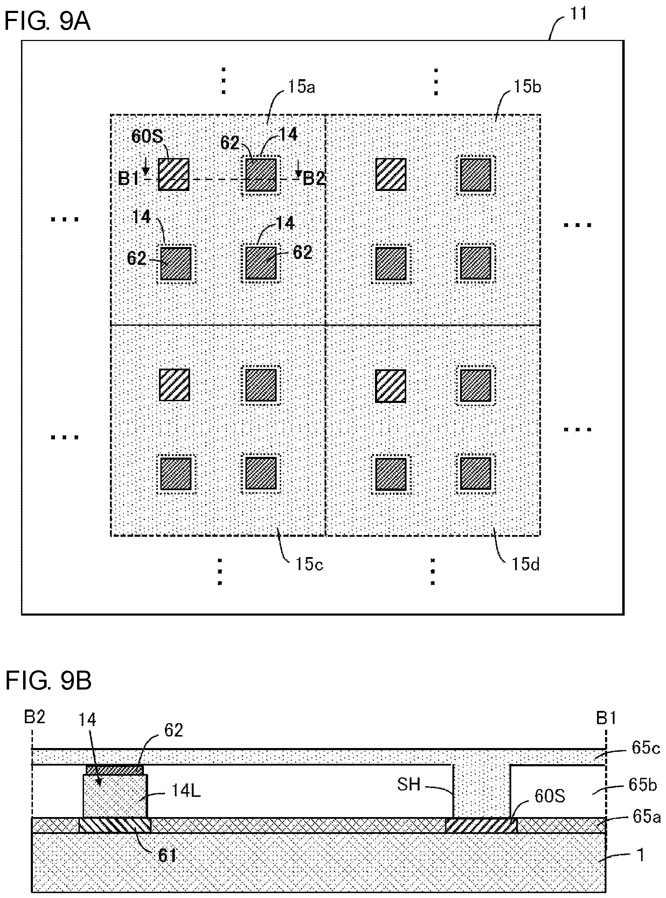

FIG. 9A is a plan view of four pixel units 15a, 15b, 15c, and 15d included in an effective area 11. FIG. 9B is a cross-sectional view taken along line B1-B2 in FIG. 9A as viewed in the direction indicated by arrows. Vertical light emitters 14 each include a first electrode 61 (shown in FIG. 9B) on the glass substrate 1, an emissive layer 14L (shown in FIG. 9B) on the first electrode 61, and a second electrode 62 (shown in FIGs. 9A and 9B) on the emissive layer 14L. The first electrode 61 is, for example, a positive electrode, and the second electrode 62 is, for example, a negative electrode.

As shown in FIG. 9A, each of the pixel units 15a to 15d includes a power electrode pad 60S that commonly provides a negative electric potential to each of the second electrodes 62 in the multiple light emitters 14. As shown in FIG. 9B, the pixel units 15a to 15d also include, in their upper portions, a conductive film 65c or a transparent conductive film including, for example, indium tin oxide (ITO), with which the power electrode pad 60S is electrically connected to each second electrode 62. The glass substrate 1 has a first surface receiving an insulating layer 65a including, for example, silicon oxide (SiO₂) and silicon nitride (Si₃N₄), a planarizing layer 65b including an organic insulation material such as acrylic resin or polycarbonate, and the conductive film 65c in this order from the first surface. The power electrode pad 60S and the conductive film 65c are connected with a conductive connector including a feedthrough conductor such as a through-hole SH defined in the planarizing layer 65b.

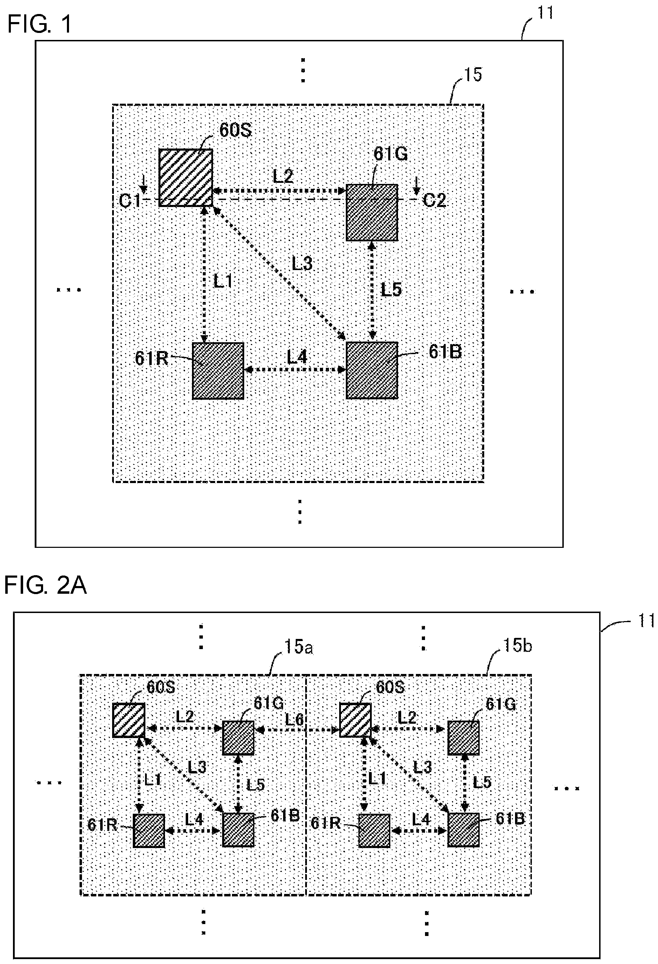

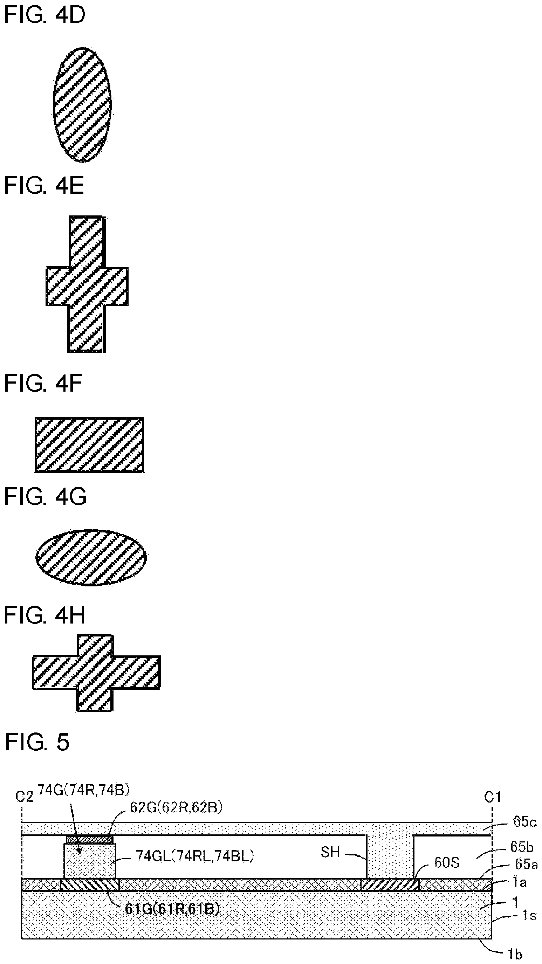

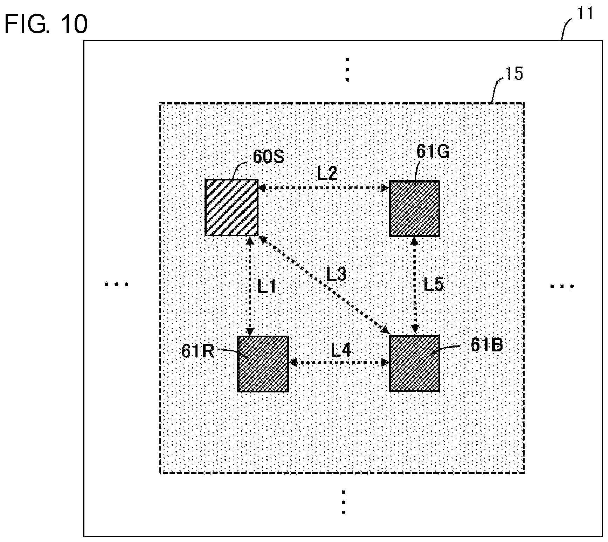

FIGs. 1 to 6 and 10 each show a micro-LED mounting board according to one or more embodiments. As shown in FIG. 1, a micro-LED mounting board includes a substrate 1 having a mount surface 1a (shown in FIG. 5) receiving micro-LEDs 74R, 74G, and 74B (shown in FIG. 5), and a pixel unit 15 located on the mount surface 1a and including the micro-LEDs 74R, 74G, and 74B having different emission colors. The pixel unit 15 is operable as a basic element of display. The micro-LEDs 74R, 74G, and 74B include first electrodes 61R, 61G, and 61B (shown in FIG. 5) on the mount surface 1a, emissive layers 74RL, 74GL, and 74BL (shown in FIG. 5) on the first electrode 61R, 61G, and 61B, and second electrodes 62R, 62G, and 62B (shown in FIG. 5) on the emissive layers 74RL, 74GL, and 74BL. The pixel unit 15 includes a power electrode pad 60S connected to each of the second electrodes 62R, 62G, and 62B in the micro-LEDs 74R, 74G, and 74B. The power electrode pad 60S is spaced from each of the first electrodes 61R, 61G, and 61B by a distance L1, L2, or L3 greater than an interelectrode distance L4 or L5 between adjacent ones of the first electrodes 61R, 61G, and 61B (shown in FIG. 1). In some embodiments, the distance L1, L2, or L3 is greater than or equal to the interelectrode distance L4 or L5 (shown in FIG. 10). In the structure in FIG. 1, when the interelectrode distances L4 and L5 are different, each of the distances L1, L2, and L3 is greater than the greater one of the interelectrode distances L4 and L5. In FIG. 1, (L1, L2, L3) > (L4, L5 and L4 = L5). In the structure in FIG. 10, when the interelectrode distances L4 and L5 are different, the distance L1, L2, or L3 is greater than or equal to the greater one of the interelectrode distances L4 and L5. In FIG. 10, L1 = L4 = L5, and (L2, L3) > (L4, L5 and L4 = L5).

This structure produces the effects described below. The power electrode pad 60S may be used as an alignment mark for positioning the emissive layers 74R, 74G, and 74B on the first electrodes 61R, 61G, and 61B. In this case, with the distance L1, L2, or L3 between the power electrode pad 60S and each of the first electrodes 61R, 61G, and 61B greater than the interelectrode distance L4 or L5 between adjacent ones of the first electrodes 61R, 61G, and 61B, the power electrode pad 60S is easily sensed optically with an imaging device such as a camera. This improves the yield in mounting many micro-LEDs 74R, 74G, and 74B and enables low cost manufacture of the micro-LED mounting board. The structure also reduces the likelihood of short-circuiting between the power electrode pad 60S and the first electrodes 61R, 61G, and 61B having different polarities. The structure with the distance L1, L2, or L3 greater than or equal to the interelectrode distance L4 or L5 also produces the same effects as described above.

In the micro-LED mounting board according to one or more embodiments, the distances L1, L2, and L3 and the interelectrode distances L4 and L5 each refer to the shortest distance. For example, the distance L3 refers to the distance between the closest points on the power electrode pad 60S and the first electrode 61B.

As shown in FIGs. 2A to 3B, the first electrodes 61R, 61G, and 61B may be arranged in the same pattern in multiple pixel units 15. In some embodiments, the pattern may be different in each pixel unit 15.

In the micro-LED mounting board according to one or more embodiments, the substrate 1 may be a translucent substrate such as a glass substrate and a plastic substrate, or a non-translucent substrate such as a ceramic substrate, a non-translucent plastic substrate, and a metal substrate. The substrate 1 may further be a composite substrate including a laminate of a glass substrate and a plastic substrate, a laminate of a glass substrate and a ceramic substrate, a laminate of a glass substrate and a metal substrate, or a laminate of at least any two of the above substrates formed from different materials. The substrate 1 including an electrically insulating substrate, such as a glass substrate, a plastic substrate, or a ceramic substrate, allows easy formation of wiring conductors. The substrate 1 may be rectangular, circular, oval, trapezoidal, or in any other shape.

The micro-LEDs 74R, 74G, and 74B on the micro-LED mounting board according to one or more embodiments are self-luminous and free of backlight, and have high efficiency and a longer service life. The micro-LEDs 74R, 74G, and 74B are mounted vertically on (perpendicularly to) the mount surface 1a of the substrate 1. The mounted micro-LEDs include the first electrodes 61R, 61G, and 61B, the emissive layers 74RL, 74GL, and 74BL, and the second electrodes 62R, 62G, and 62B stacked in this order from the mount surface 1a.

Each of the micro-LEDs 74R, 74G, and 74B rectangular as viewed in plan may have, but is not limited to, a size of at least about 1 µm and not more than 100 µm on each side, or more specifically of at least about 3 µm and not more than 10 µm on each side.

The micro-LEDs 74R, 74G, and 74B have different emission colors. For example, the micro-LED 74R emits red, orange, red-orange, red-violet, or violet light. The micro-LED 74G emits green or yellow-green light. The micro-LED 74B emits blue light. The micro-LED mounting board with such micro-LEDs facilitates fabrication of a color display device. A pixel unit 15 including three or more micro-LEDs may have two or more micro-LEDs having the same emission color.

One pixel unit 15 may include four or more micro-LEDs. For example, one pixel unit 15 may include two sets of micro-LEDs each including one red-light emissive micro-LED 74R, one green-light emissive micro-LED 74G, and one blue-light emissive micro-LED 74B (six micro-LEDs in total). In this case, one set may be activated primarily, and the other may be activated redundantly.

The first electrodes 61R, 61G, and 61B in the micro-LEDs 74R, 74G, and 74B are positive electrodes for providing a positive electric potential to the emissive layers 74RL, 74GL, and 74BL in the micro-LEDs 74R, 74G, and 74B. The second electrodes 62R, 62G, and 62B are negative electrodes for providing a negative electric potential to the emissive layers 74RL, 74GL, and 74BL in the micro-LEDs 74R, 74G, and 74B. In some embodiments, the first electrodes 61R, 61G, and 61B may be negative electrodes, and the second electrodes 62R, 62G, 62B may be positive electrodes.

The first electrodes 61R, 61G, and 61B and the second electrodes 62R, 62G, and 62B are conductor layers including, for example, tantalum (Ta), tungsten (W), titanium (Ti), molybdenum (Mo), aluminum (Al), chromium (Cr), silver (Ag), or copper (Cu). The first electrodes 61R, 61G, and 61B and the second electrodes 62R, 62G, and 62B may be metal layers including Mo/Al/Mo layers (indicating a stack of a Mo layer, an Al layer, and a Mo layer in this order) or metal layer(s) including an Al layer, Al/Ti layers, Ti/Al/Ti layers, a Mo layer, Mo/Al/Mo layers, Ti/Al/Mo layers, Mo/Al/Ti layers, a Cu layer, a Cr layer, a Ni layer, or a Ag layer. The power electrode pad 60S may have the same structure as the first electrodes 61R, 61G, and 61B and the second electrodes 62R, 62G, and 62B.

The pixel unit 15, including the micro-LEDs 74R, 74G, and 74B with different emission colors, functions as a basic element of display. For example, a color display device includes pixel units each including a red-light emissive micro-LED 74R, a green-light emissive micro-LED 74G, and a blue-light emissive micro-LED 74B to enable display of color tones.

In some embodiments, the micro-LEDs 74R, 74G, and 74B are not aligned on a single straight line as viewed in plan. In this case, the pixel unit 15 is smaller as viewed in plan, and may be compact and square as viewed in plan. The display device or other devices thus include pixels with higher density and less irregularities, enabling high-quality image display.

The pixel unit 15 may include an emission controller including a TFT, serving as a switch or a control element for controlling the emission or non-emission state and the light intensity of the micro-LEDs 74R, 74G, and 74B. The emission controller may be located below the micro-LEDs 74R, 74G, and 74B with an insulating layer in between.

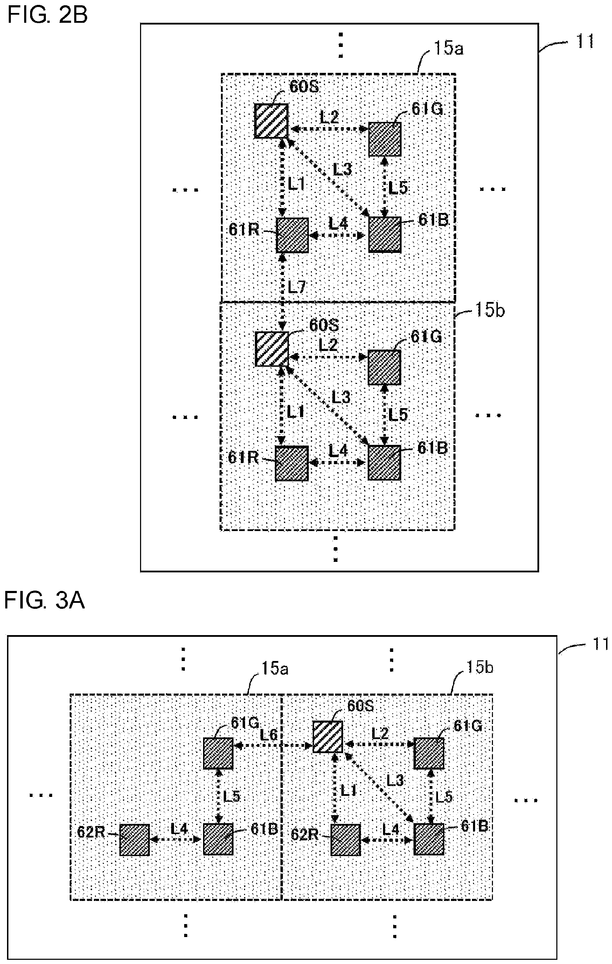

As shown in FIGs. 2A and 2B, the micro-LED mounting board according to one or more embodiments may include multiple pixel units 15. The power electrode pad 60S in a pixel unit 15b may be spaced, by a distance L6 (L7) greater than the interelectrode distances L4 or L5, from the first electrode 61G (61R) in the micro-LED 74G (74R) closest to the power electrode pad 60S in the pixel unit 15b, of the micro-LEDs 74R, 74G, and 74B included in a pixel unit 15a adjacent to the pixel unit 15b. This structure facilitates optical sensing of the power electrode pad with an imaging device such as a camera.

In FIG. 2A, two pixel units 15a and 15b are aligned laterally (in a row direction). In FIG. 2B, two pixel units 15a and 15b are aligned vertically (in a column direction).

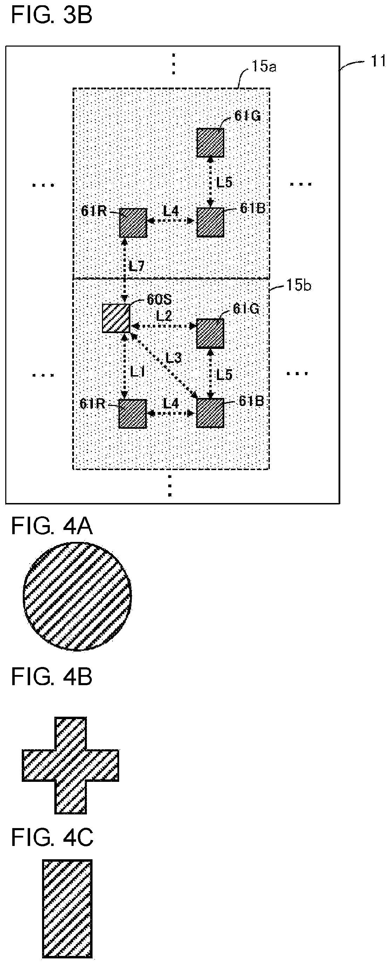

In the micro-LED mounting board according to one or more embodiments, the power electrode pad 60S may have a shape different from the shape of each of the first electrodes 61R, 61G, and 61B (rectangular in FIGs. 3A and 3B). Such a power electrode pad 60S used as an alignment mark to position the emissive layers 74RL, 74GL, and 74BL on the first electrodes 61R, 61G, and 61B is easily sensed optically with an imaging device such as a camera.

FIGs. 4A to 4H each are a plan view of the power electrode pad 60S in different shapes. In FIG. 4A, the power electrode pad 60S is circular and thus is isotropic. In the structure in FIG. 1, such a power electrode pad 60S can reduce an ununiform voltage drop in the negative potential provided to the micro-LEDs 74R, 74G, and 74B.

In FIG. 4B, the power electrode pad 60S is cross-shaped. The cross-shaped power electrode pad 60S functions as a vertical and lateral guide. The center of the cross functions effectively as an alignment mark.

As shown in FIGs. 4C to 4H, the power electrode pad 60S may be longer in a direction parallel to a boundary between pixel units than in a direction orthogonal to the boundary. Such a power electrode pad 60S is elongated in the direction parallel to the boundary, becoming less conspicuous in the display device or other devices.

In FIG. 4C, the power electrode pad 60S is rectangular and longer in a direction parallel to a boundary extending vertically (in the column direction) than in the direction orthogonal to the boundary.

In FIG. 4D, the power electrode pad 60S is oval or elliptical and longer in the direction parallel to the boundary extending vertically (in the column direction) than in the direction orthogonal to the boundary.

In FIG. 4E, the power electrode pad 60S is cross-shaped and longer in the direction parallel to the boundary extending vertically (in the column direction) than in the direction orthogonal to the boundary.

In FIG. 4F, the power electrode pad 60S is rectangular and is longer in a direction parallel to a boundary extending laterally (in the row direction) than in the direction orthogonal to the boundary.

In FIG. 4G, the power electrode pad 60S is oval or elliptical and longer in the direction parallel to the boundary extending laterally (in the row direction) than in the direction orthogonal to the boundary.

In FIG. 4H, the power electrode pad 60S is cross-shaped and longer in the direction parallel to the boundary extending laterally (in the row direction) than in the direction orthogonal to the boundary.

In the micro-LED mounting board according to one or more embodiments, the power electrode pad 60S may have an area different from that of each of the first electrodes 61R, 61G, and 61B as viewed in plan. Such a power electrode pad 60S used as an alignment mark to position the emissive layers 74RL, 74GL, and 74BL on the first electrodes 61R, 61G, and 61B is easily sensed optically with an imaging device such as a camera.

In the micro-LED mounting board according to one or more embodiments, the power electrode pad 60S may have a larger area than each of the first electrodes 61R, 61G, and 61B as viewed in plan. Such a power electrode pad 60S used as an alignment mark to position the emissive layers 74RL, 74GL, and 74BL on the first electrodes 61R, 61G, and 61B is easily sensed optically with an imaging device such as a camera. This structure with the relationship (L1, L2, L3) > (L4, L5) or the relationship (L1, L2, L3) > (L4, L5) and (L6, L7) > (L4, L5) facilitates optical sensing of the power electrode pad 60S with an imaging device such as a camera. The structure reduces the likelihood of short-circuiting between the power electrode pad 60S and the first electrodes 61R, 61G, and 61B having different pluralities.

The power electrode pad 60S may have a smaller area than each of the first electrodes 61R, 61G, and 61B as viewed in plan. In this case, the second electrodes 62R, 62G, and 62B each also have about the same area as each of the first electrodes 61R, 61G, and 61B as viewed in plan. The power electrode pad 60S is thus less viewable on the display device or other devices. This structure reduces deteriorating image quality in the display device.

The power electrode pad 60S may have an area different from that of the first electrodes 61R, 61G, and 61B as viewed in plan within a range of Sp/S1r being about 0.1 to 10.0, where Sp is the area of the power electrode pad 60S as viewed in plan and S1r, S1g, or S1b (S1r=S1g=S1b) is the area of each of the first electrodes 61R, 61G, and 61B as viewed in plan. At the value Sp/S1r less than 0.1, the power electrode pad 60S can be less easily sensed optically. At the value of Sp/S1r greater than 10.0, the power electrode pad 60S tends to be conspicuous in the display device or other devices. In some embodiments, the areas may vary within a range of Sp/S1r being about 0.5 to 2.0.

In the micro-LED mounting board according to one or more embodiments, the power electrode pad 60S may have a light reflectance different from that of each of the first electrodes 61R, 61G, and 61B. Such a power electrode pad 60S used as an alignment mark to position the emissive layers 74RL, 74GL, and 74BL on the first electrodes 61R, 61G, and 61B is easily sensed optically with an imaging device such as a camera.

For example, the power electrode pad 60S may have a rough surface, which scatters light. The surface of the power electrode pad 60S may have an arithmetic mean roughness of 50 µm or less, or more specifically of 10 µm or less. To avoid smoother surface of the power electrode pad 60S and increased reflectance, the surface of the power electrode pad 60S may have an arithmetic mean roughness of 0.1 µm or greater. The surface of the power electrode pad 60S may be roughened by, for example, etching or dry etching, or controlling the film deposition time and temperature in forming the power electrode pad 60S with a thin film formation method, such as chemical vapor deposition (CVD). Grain structures such as giant single crystal grains and giant polycrystal grains form in the power electrode pad 60S.

The power electrode pad 60S may be dark colored, such as in black, blackish brown, or dark blue. The power electrode pad 60S can be colored in such dark colors by forming at least its surface layer with, for example, a chromium (Cr) layer, a carbon layer, or a layer containing carbon.

In the micro-LED mounting board according to one or more embodiments, the power electrode pad 60S is more optically sensible than the first electrodes 61R, 61G, and 61B in an invisible light region. In this case, the power electrode pad 60S used as an alignment mark to position the emissive layers 74RL, 74GL, and 74BL on the first electrodes 61R, 61G, and 61B may be formed to, for example, emit light under black light that emits ultraviolet (UV) rays of a long wavelength (315 to 400 nm), which is slightly visible to human eyes. Such a power electrode pad 60S is far more conspicuous than the first electrodes 61R, 61G, and 61B under black light. This further facilitates optical sensing of the power electrode pad 60S.

The power electrode pad 60S that emits light under black light may include a phosphor that emits light under black light. Examples of the phosphor include strontium fluoroborate doped with a small amount of europium (SrB₄O₇F:Eu²⁺, with a peak wavelength of 368 to 371 nm) and lead-doped barium silicide (BaSi₂O₅:Pb⁺, with a peak wavelength of 350 to 353 nm).

In the micro-LED mounting board according to one or more embodiments, the power electrode pad 60S may be used as an alignment mark to position the emissive layers 74RL, 74GL, and 74BL on the first electrodes 61R, 61G, and 61B. This facilitates optical sensing of the power electrode pad 60S with an imaging device such as a camera, thus improving the yield in mounting many micro-LEDs and enabling low cost manufacture of the micro-LED mounting board.

In the micro-LED mounting board according to one or more embodiments, the power electrode pad 60S may be less optically sensible than the second electrodes 62R, 62G, and 62B in a visible light region. The power electrode pad 60S is thus inconspicuous in the images appearing on the display device or other devices including the micro-LED mounting board according to one or more embodiments. This reduces deteriorating display quality in the display device or other devices. The above structure is achieved with, for example, the power electrode pad 60S having a smaller area than each of the second electrodes 62R, 62G, and 62B as viewed in plan or have a smaller light reflectance than each of the second electrodes 62R, 62G, and 62B. As described above, the power electrode pad 60S with a smaller light reflectance than the second electrodes 62R, 62G, and 62B has, for example, a rough surface or is dark colored, such as in black, blackish brown, or dark blue.

The micro-LED mounting board, including the power electrode pad 60S less optically sensible than the second electrodes 62R, 62G, and 62B in the visible light region, may include a light absorber on the power electrode pad 60S. The power electrode pad 60S is thus more inconspicuous in the images appearing on the display device or other devices including the micro-LED mounting board according to one or more embodiments of the present disclosure. This further reduces deteriorating display quality in the display device or other devices. The light absorber may be a light-absorbing layer in a dark color, such as black, blackish brown, or dark blue. The light-absorbing layer in a dark color may be formed by mixing dark-colored ceramic particles, plastic particles, or carbon particles into a resin layer formed from an organic resin such as acrylic resin or polycarbonate. More specifically, a resin paste including, for example, an uncured resin component, an alcohol solvent, water, and dark-colored particles may be cured by heating, photocuring using UV ray irradiation, or a combination of photocuring and heating.

As shown in FIG. 5, the micro-LED mounting board according to one or more embodiments may include a conductive film 65c on the pixel unit 15. The conductive film 65c conducts the negative potential from the power electrode pad 60S commonly to each of the second electrodes 62R, 62G, and 62B in the micro-LEDs 74R, 74G, and 74B. The conductive film 65c may extend across multiple pixel units or all the pixel units. The conductive film 65c may include a translucent and conductive material such as indium tin oxide (ITO), indium zinc oxide (IZO), silicon oxide-doped indium tin oxide (ITSO), zinc oxide (ZnO), and silicon (Si) containing phosphorus and boron. The conductive film 65c including such materials facilitates emission of light from the micro-LEDs 74R, 74G, and 74B outward from the mount surface (front surface) 1a of the substrate 1. When the conductive film 65c is non-translucent, light from the micro-LEDs 74R, 74G, and 74B may be emitted outward from the opposite surface (back surface) 1b of the translucent or glass substrate 1 to form a back-illuminated device.

The planarizing layer 65b may be dark colored, such as in black, blackish brown, or dark blue. The dark colored planarizing layer 65b allows the display device or other devices including the micro-LED mounting board to show dark color or, for example, black on the background of the display unit 11, thus increasing the contrast and thus the display quality of the display device. The planarizing layer 65b may be dark colored by, for example, mixing dark-colored ceramic particles or plastic particles into the planarizing layer 65b formed from an organic resin such as acrylic resin or polycarbonate.

As shown in FIGs. 3A and 3B, a micro-LED mounting board according to one or more embodiments includes a substrate 1 having a mount surface 1a receiving micro-LEDs, and multiple pixel units located on the mount surface 1a. Each of the multiple pixel units includes micro-LEDs 74R, 74G, and 74B having different emission colors to operate as a basic element of display. The micro-LEDs 74R, 74G, and 74B include first electrodes 61R, 61G, and 61B on the mount surface 1a, emissive layers 74RL, 74GL, and 74BL on the first electrodes 61R, 61G, and 61B, and second electrodes 62R, 62G, and 62B on the emissive layers 74RL, 74GL, and 74BL. The multiple pixel units 15a and 15b include a first pixel unit 15b including a power electrode pad 60S connected to each of the second electrodes 62R, 62G, and 62B in the micro-LEDs 74R, 74G, and 74B and a second pixel unit 15a adjacent to the first pixel unit 15b and free of the power electrode pad 60S. The power electrode pad 60S is spaced from each of the first electrodes 61R, 61G, and 61B in the first pixel unit 15b by a distance L1, L2, or L3 greater than an interelectrode distance L4 or L5 between adjacent ones of the first electrodes 61R, 61G, and 61B in the first pixel unit 15b. The power electrode pad 60S is spaced, by a distance (distance L6 in FIG. 3A or distance L7 in FIG. 3B) greater than an interelectrode distance L4 or L5 between adjacent ones of the first electrodes 61R, 61G, and 61B in the second pixel unit 15a, from a first electrode (the first electrode 61G in FIG. 3A, the first electrode 61R in FIG. 3B) in a micro-LED closest to the power electrode pad 60S of the micro-LEDs 74R, 74G, and 74B included in the second pixel unit 15a.

This structure produces the effects described below. The power electrode pad 60S used as an alignment mark to position the emissive layers 74RL, 74GL, and 74BL on the first electrodes 61R, 61G, and 61B is easily sensed optically with an imaging device such as a camera. The display device and other devices including the micro-LED mounting board according to the embodiment include fewer power electrode pads 60S, which are less visible. This reduces deteriorating display quality in the display device or other devices. Such fewer electrodes simplify the wiring in the display device or other devices, thus enabling low cost manufacture of the display device or other devices.

In FIG. 3A, two pixel units or the first pixel unit 15b and the second pixel unit 15a are aligned laterally (in a row direction). In FIG. 3B, two pixel units or the first pixel unit 15b and the second pixel unit 15a are aligned vertically (in a column direction). In some embodiments, three or more pixel units may be aligned laterally or vertically and may correspond to one power electrode pad 60S.

A display device according to one or more embodiments includes the micro-LED mounting board according to the above embodiments. The substrate 1 has an opposite surface 1b opposite to the mount surface 1a, and a side surface Is. The micro-LED mounting board includes side wiring 30 on the side surface Is and a driver 6 on the opposite surface 1b. The display device includes multiple pixel units arranged in a matrix. The micro-LEDs 74R, 74G, and 74B are connected to the driver 6 with the side wiring 30. The display device with this structure includes the micro-LEDs 74R, 74G, and 74B aligned accurately, thus reducing irregularities or variations in the emissive area. The structure also improves the manufacturing yield, thus enabling low cost manufacture of the display device.

The display device according to one or more embodiments may include multiple substrates 1 each including multiple micro-LEDs. The multiple substrates 1 may be arranged in a grid on the same plane. The substrates 1 may be connected (tiled) together with their side surfaces bonded with, for example, an adhesive. The display device can thus be composite and large, forming a multi-display.

The driver 6 may include driving elements such as ICs and LSI circuits mounted by chip on glass or may be a circuit board on which driving elements are mounted. The driver 6 may also be a thin film circuit including, for example, a TFT that includes a semiconductor layer including low temperature polycrystalline silicon (LTPS) formed directly on the opposite surface 1b of the glass substrate 1 by a thin film formation method such as CVD.

The side wiring 30 may be formed from a conductive paste including conductive particles such as silver (Ag), copper (Cu), aluminum (Al), and stainless steel, an uncured resin component, an alcohol solvent, and water. The conductive paste may be cured by heating, photocuring using UV ray irradiation, or a combination of photocuring and heating. The side wiring 30 may also be formed by a thin film formation method such as plating, vapor deposition, and CVD. The substrate 1 may have a groove on the side surface Is to receive the side wiring 30. This allows the conductive paste to be easily received in the groove or in an intended portion on the side surface 1s.

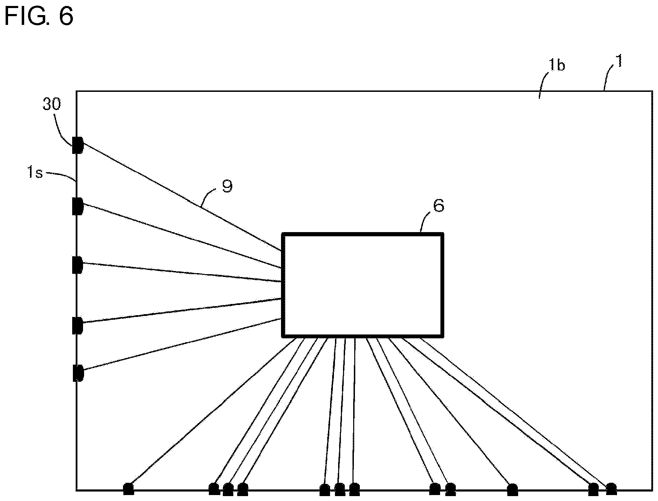

The display device according to one or more embodiments may function as a light-emitting device. The light-emitting device includes the micro-LED mounting board according to the above embodiments. As shown in FIG. 6, the substrate 1 has an opposite surface 1b opposite to the mount surface 1a, and a side surface Is. The micro-LED mounting board includes side wiring 30 on the side surface Is and a driver 6 on the opposite surface 1b. The micro-LEDs 74R, 74G, and 74B are connected to the driver 6 with the side wiring 30. The light-emitting device with this structure includes the micro-LEDs 74R, 74G, and 74B aligned accurately, thus reducing irregularities or variations in the emissive area. The structure also improves the manufacturing yield, thus enabling low cost manufacture of the display device.

The light-emitting device in one or more embodiments can be used as, for example, a printer head for an image formation device and other devices, an illumination device, a signboard, and a notice board.

A micro-LED mounting board according to one or more embodiments includes a substrate 1 having a mount surface 1a receiving micro-LEDs 74R, 74G, and 74B, and a pixel unit 15 located on the mount surface 1a and including the micro-LEDs 74R, 74G, and 74B to operate as a basic element of display. The micro-LEDs 74R, 74G, and 74B include first electrodes 61R, 61G, and 61B on the mount surface 1a, emissive layers 74RL, 74GL, and 74BL on the first electrode 61R, 61G, and 61B, and second electrodes 62R, 62G, and 62B on the emissive layers 74RL, 74GL, and 74BL. The pixel unit 15 includes a power electrode pad 60S connected to each of the second electrodes 62R, 62G, and 62B in the micro-LEDs 74R, 74G, and 74B. The power electrode pad 60S is spaced from each of the first electrodes 61R, 61G, and 61B by a distance L1, L2, or L3 greater than an interelectrode distance L4 or L5 between adjacent ones of the first electrodes 61R, 61G, and 61B. This structure produces the effects described below. The power electrode pad 60S used as an alignment mark to position the emissive layers 74RL, 74GL, and 74BL on the first electrodes 61R, 61G, and 61B is easily sensed optically with an imaging device such as a camera. This improves the yield in mounting many micro-LEDs 74R, 74G, and 74B and enables low cost manufacture of the micro-LED mounting board. The structure also reduces the likelihood of short-circuiting between the power electrode pad 60S and the first electrodes 61R, 61G, and 61B having different polarities. In some embodiments, the micro-LED mounting board and the display device may include multiple micro-LEDs of the same emission color and color converters such as phosphors or color filters. The resulting mounting board or the display device is free of inefficient red-light emissive micro-LEDs, thus reducing power consumption.

The pixel unit 15 including multiple micro-LEDs of the same emission color may include the various structures described below. The pixel unit 15 may include a red light emitter including a UV-light emissive micro-LED, a red light converter including a phosphor, and a red color filter, a green light emitter including a UV-light emissive micro-LED, a green light converter including a phosphor, and a green color filter, and a blue light emitter including a UV-light emissive micro-LED, a blue light converter including a phosphor, and a blue color filter. In some embodiments, the pixel unit 15 may include a red light emitter including a blue-light emissive micro-LED, a red light converter, and a red color filter, a green light emitter including a blue-light emissive micro-LED, a green light converter, and a green color filter, and a blue light emitter including a blue-light emissive micro-LED. In some embodiments, the pixel unit 15 may include a red light emitter including a blue-light emissive micro-LED, a red light converter, and a red color filter, a green light emitter including a green-light emissive micro-LED, and a blue light emitter including a blue-light emissive micro-LED.

As shown in FIG. 10, a micro-LED mounting board according to one or more embodiments includes a substrate 1 having a mount surface 1a receiving micro-LEDs 74R, 74G, and 74B, and a pixel unit 15 located on the mount surface 1a and including the micro-LEDs 74R, 74G, and 74B having different emission colors. The pixel unit 15 is operable as a basic element of display. The micro-LEDs 74R, 74G, and 74B include first electrodes 61R, 61G, and 61B on the mount surface 1a, emissive layers 74RL, 74GL, and 74BL on the first electrode 61R, 61G, and 61B, and second electrodes 62R, 62G, and 62B on the emissive layers 74RL, 74GL, and 74BL. The pixel unit 15 includes a power electrode pad 60S connected to each of the second electrodes 62R, 62G, and 62B in the micro-LEDs 74R, 74G, and 74B. The power electrode pad 60S is spaced from each of the first electrodes 61R, 61G, and 61B by a distance L1 equal to an interelectrode distance L4 or L5 between adjacent ones of the first electrodes 61R, 61G, and 61B or by a distance L2 greater than the interelectrode distance L4 or L5. This structure produces the effects described below. The power electrode pad 60S used as an alignment mark to position the emissive layers 74RL, 74GL, and 74BL on the first electrodes 61R, 61G, and 61B is easily sensed optically with an imaging device such as a camera. This improves the yield in mounting many micro-LEDs 74R, 74G, and 74B and enables low cost manufacture of the micro-LED mounting board. The structure also reduces the likelihood of short-circuiting between the power electrode pad 60S and the first electrodes 61R, 61G, and 61B having different polarities.

The micro-LED mounting board and the display device according to the present invention are not limited to the above embodiments and may include design alternations and improvements as appropriate. For example, the substrate 1 may be non-translucent, and may be a glass substrate colored in black, gray, or other colors, or a glass substrate including frosted glass.

The embodiments of the present disclosure may be implemented in the forms described below.

A micro-light-emitting diode mounting board according to one or more embodiments of the present disclosure includes a substrate having a mount surface receiving a plurality of micro-light-emitting diodes (LEDs), and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes.

In the micro-light-emitting diode mounting board according to one or more embodiments of the present disclosure, the at least one pixel unit may include a plurality of pixel units. The power electrode pad in one of the plurality of pixel units may be spaced, by a distance greater than the interelectrode distance, from a first electrode in a micro-LED closest to the power electrode pad in the one pixel unit, of the plurality of micro-LEDs included in another of the plurality of pixel units adjacent to the one first pixel unit.

In the micro-light-emitting diode mounting board according to one or more embodiments of the present disclosure, the power electrode pad may have a shape different from a shape of each of the plurality of first electrodes.

In the micro-light-emitting diode mounting board according to one or more embodiments of the present disclosure, the power electrode pad may have an area different from an area of each of the plurality of first electrodes as viewed in plan.

In the micro-light-emitting diode mounting board according to one or more embodiments of the present disclosure, the power electrode pad may have a larger area than each of the plurality of first electrodes as viewed in plan.

In the micro-light-emitting diode mounting board according to one or more embodiments of the present disclosure, the power electrode pad may have a light reflectance different from a light reflectance of each of the plurality of first electrodes.

In the micro-light-emitting diode mounting board according to one or more embodiments of the present disclosure, the power electrode pad may be more optically sensible than each of the plurality of first electrodes in an invisible light region.

In the micro-light-emitting diode mounting board according to one or more embodiments of the present disclosure, the power electrode pad may be usable as an alignment mark to position the plurality of emissive layers on the plurality of first electrodes.

A micro-light-emitting diode mounting board according to one or more embodiments of the present disclosure includes a substrate having a mount surface receiving a plurality of micro-LEDs, and a plurality of pixel units on the mount surface. Each of the plurality of pixel units includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The plurality of pixel units include a first pixel unit including a power electrode pad connected to each of the plurality of second electrodes in the plurality of micro-LEDs and a second pixel unit adjacent to the first pixel unit and free of the power electrode pad. The power electrode pad is spaced from each of the plurality of first electrodes in the first pixel unit by a distance greater than an interelectrode distance between adjacent first electrodes of the plurality of first electrodes in the first pixel unit. The power electrode pad is spaced, by a distance greater than an interelectrode distance between adjacent first electrodes of the plurality of first electrodes in the second pixel unit, from a first electrode in a micro-LED closest to the power electrode pad of the plurality of micro-LEDs included in the second pixel unit.

A display device according to one or more embodiments of the present disclosure includes the micro-light-emitting diode mounting board. The substrate has an opposite surface opposite to the mount surface, and a side surface. The micro-light-emitting diode mounting board includes side wiring on the side surface and a driver on the opposite surface. The at least one pixel unit includes a plurality of pixel units arranged in a matrix. The plurality of micro-LEDs are connected to the driver with the side wiring.

A micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes. The power electrode pad is less optically sensible than each of the plurality of second electrodes in a visible light region.

The micro-light-emitting diode mounting board according to one or more embodiments of the present disclosure may further include a light absorber on the power electrode pad.

A micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes.

A micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than or equal to an interelectrode distance between adjacent first electrodes of the plurality of first electrodes.

The micro-light-emitting diode mounting board according to one or more embodiments of the present disclosure includes a substrate having a mount surface receiving a plurality of micro-light-emitting diodes (LEDs), and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes. This structure produces the effects described below. The power electrode pad may be used as an alignment mark for positioning the emissive layers on the first electrodes. The power electrode pad is spaced from each of the first electrodes by a distance greater than the interelectrode distance between any adjacent ones of the first electrodes. This structure facilitates optical sensing of the power electrode pad with an imaging device such as a camera. This improves the yield in mounting many micro-LEDs and enables low cost manufacture of the micro-LED mounting board. The structure also reduces the likelihood of short-circuiting between the power electrode pad and the first electrodes having different polarities.

In the micro-light-emitting diode mounting board according to one or more embodiments of the present disclosure, the at least one pixel unit may include a plurality of pixel units. The power electrode pad in one of the plurality of pixel units may be spaced, by a distance greater than the interelectrode distance, from a first electrode in a micro-LED closest to the power electrode pad in the one pixel unit, of the plurality of micro-LEDs included in another of the plurality of pixel units adjacent to the one first pixel unit. The structure further facilitates optical sensing of the power electrode pad with an imaging device such as a camera.

In the micro-light-emitting diode mounting board according to one or more embodiments of the present disclosure, the power electrode pad may have a shape different from a shape of each of the plurality of first electrodes. Such a power electrode pad used as an alignment mark to position the emissive layers on the first electrodes is easily sensed optically with an imaging device such as a camera.

In the micro-light-emitting diode mounting board according to one or more embodiments of the present disclosure, the power electrode pad may have an area different from an area of each of the plurality of first electrodes as viewed in plan. Such a power electrode pad used as an alignment mark to position the emissive layers on the first electrodes is easily sensed optically with an imaging device such as a camera.

In the micro-light-emitting diode mounting board according to one or more embodiments of the present disclosure, the power electrode pad may have a larger area than each of the plurality of first electrodes as viewed in plan. Such a power electrode pad used as an alignment mark to position the emissive layers on the first electrodes is easily sensed optically with an imaging device such as a camera.

In the micro-light-emitting diode mounting board according to one or more embodiments of the present disclosure, the power electrode pad may have a light reflectance different from a light reflectance of each of the plurality of first electrodes. Such a power electrode pad used as an alignment mark to position the emissive layers on the first electrodes is easily sensed optically with an imaging device such as a camera.

In the micro-light-emitting diode mounting board according to one or more embodiments of the present disclosure, the power electrode pad may be more optically sensible than each of the plurality of first electrodes in an invisible light region. The power electrode pad used as an alignment mark to position the emissive layers on the first electrodes may be formed to, for example, emit light under black light that emits UV rays of a long wavelength, which is slightly visible to human eyes. Such a power electrode pad is far more conspicuous than the first electrodes under black light. The power electrode pad is thus easily sensed optically.

In the micro-light-emitting diode mounting board according to one or more embodiments of the present disclosure, the power electrode pad may be usable as an alignment mark to position the plurality of emissive layers on the plurality of first electrodes. Such a power electrode pad is easily sensed optically with an imaging device such as a camera, thus improving the yield in mounting many micro-LEDs and enabling low cost manufacture of the micro-LED mounting board.

The micro-light-emitting diode mounting board according to one or more embodiments of the present disclosure includes a substrate having a mount surface receiving a plurality of micro-LEDs, and a plurality of pixel units on the mount surface. Each of the plurality of pixel units includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The plurality of pixel units include a first pixel unit including a power electrode pad connected to each of the plurality of second electrodes in the plurality of micro-LEDs and a second pixel unit adjacent to the first pixel unit and free of the power electrode pad. The power electrode pad is spaced from each of the plurality of first electrodes in the first pixel unit by a distance greater than an interelectrode distance between adjacent first electrodes of the plurality of first electrodes in the first pixel unit. The power electrode pad is spaced, by a distance greater than an interelectrode distance between adjacent first electrodes of the plurality of first electrodes in the second pixel unit, from a first electrode in a micro-LED closest to the power electrode pad of the plurality of micro-LEDs included in the second pixel unit. This structure produces the effects described below.

The power electrode pad used as an alignment mark to position the emissive layers on the first electrodes is easily sensed optically with an imaging device such as a camera. The display device and other devices including the micro-LED mounting board according to one or more embodiments of the present disclosure include fewer power electrode pads, which are less visible. This reduces deteriorating display quality in the display device or other devices. The fewer electrodes simplify the wiring in the display device or other devices, thus enabling low cost manufacture of the display device or other devices.

The display device according to one or more embodiments of the present disclosure includes the micro-light-emitting diode mounting board according to the above embodiments of the present disclosure. The substrate has an opposite surface opposite to the mount surface, and a side surface. The micro-light-emitting diode mounting board includes side wiring on the side surface and a driver on the opposite surface. The at least one pixel unit includes a plurality of pixel units arranged in a matrix. The plurality of micro-LEDs are connected to the driver with the side wiring. The display device with this structure includes the micro-LEDs aligned accurately, thus reducing irregularities or variations in the emissive area. The structure also improves the manufacturing yield, thus enabling low cost manufacture of the display device.

The micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes. The power electrode pad is less optically sensible than each of the plurality of second electrodes in a visible light region. This structure produces the effects described below. The power electrode pad is inconspicuous in the images appearing on the display device or other devices including the micro-LED mounting board according to one or more embodiments of the present disclosure. This reduces deteriorating display quality in the display device or other devices.

The micro-light-emitting diode mounting board according to one or more embodiments of the present disclosure may further include a light absorber on the power electrode pad. The power electrode pad is inconspicuous in the images appearing on the display device or other devices including the micro-LED mounting board according to one or more embodiments of the present disclosure. This further reduces deteriorating display quality in the display device or other devices.

The micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than an interelectrode distance between adjacent first electrodes of the plurality of first electrodes. This structure produces the effects described below. The power electrode pad may be used as an alignment mark for positioning the emissive layers on the first electrodes. The power electrode pad is spaced from each of the first electrodes by a distance greater than the interelectrode distance between any adjacent ones of the first electrodes. This structure facilitates optical sensing of the power electrode pad with an imaging device such as a camera. This improves the yield in mounting many micro-LEDs and enables low cost manufacture of the micro-LED mounting board. The structure also reduces the likelihood of short-circuiting between the power electrode pad and the first electrodes having different polarities. In some embodiments, the micro-LED mounting board and the display device may include multiple micro-LEDs of the same emission color and color converters such as phosphors or color filters. The resulting mounting board or the display device is free of inefficient red-light emissive micro-LEDs, thus reducing power consumption.

The micro-light-emitting diode mounting board according to one or more embodiments of the present disclosure includes a substrate having a mount surface receiving a plurality of micro-LEDs, and at least one pixel unit on the mount surface. The at least one pixel unit includes the plurality of micro-LEDs having different emission colors to operate as a basic element of display. The plurality of micro-LEDs include a plurality of first electrodes on the mount surface, a plurality of emissive layers on the plurality of first electrodes, and a plurality of second electrodes on the plurality of emissive layers. The at least one pixel unit includes a power electrode pad connected to each of the plurality of second electrodes in the plurality of micro-LEDs. The power electrode pad is spaced from each of the plurality of first electrodes by a distance greater than or equal to an interelectrode distance between adjacent first electrodes of the plurality of first electrodes. This structure produces the effects described below. The power electrode pad used as an alignment mark to position the emissive layers on the first electrodes is easily sensed optically with an imaging device such as a camera. This improves the yield in mounting many micro-LEDs and enables low cost manufacture of the micro-LED mounting board. The structure also reduces the likelihood of short-circuiting between the power electrode pad and the first electrodes having different polarities.

### INDUSTRIAL APPLICABILITY

The display device according to the present disclosure can be used in various electronic devices. Such electronic devices include composite and large display devices (multi-displays), automobile route guidance systems (car navigation systems), ship route guidance systems, aircraft route guidance systems, smartphones, mobile phones, tablets, personal digital assistants (PDAs), video cameras, digital still cameras, electronic organizers, electronic books, electronic dictionaries, personal computers, copiers, terminals for game devices, television sets, product display tags, price display tags, programmable display devices for industrial use, car audio systems, digital audio players, facsimile machines, printers, automatic teller machines (ATMs), vending machines, head-mounted displays (HMDs), digital display watches, and smartwatches.

The present disclosure may be embodied in various forms without departing from the spirit or the main features of the present disclosure. The embodiments described above are thus merely illustrative in all respects. The scope of the present disclosure is defined not by the description given above but by the claims. Any modifications and alterations contained in the claims fall within the scope of the present disclosure.

### Reference Signs List

- 1: sub strate
- 1a: mount surface
- 1b: opposite surface
- 1s: side surface
- 6: driver
- 15a, 15b: pixel unit (second pixel unit, first pixel unit)
- 30: side wiring
- 60S: power electrode pad
- 61R, 61G, 61B: first electrode
- 62R, 62G, 62B: second electrode
- 65c: conductive film
- 74R, 74G, 74B: micro-LED
- 74RL, 74GL, 74BL: emissive layer

## Claims

1. A micro-light-emitting diode mounting board, comprising:
a substrate having a mount surface receiving a plurality of micro-LEDs, the micro-LEDs being micro-light-emitting diodes; and
at least one pixel unit on the mount surface, the at least one pixel unit including the plurality of micro-LEDs having different emission colors to operate as a basic element of display, the plurality of micro-LEDs including a plurality of first electrodes on the mount surface, a plurality of emissive layers on the plurality of first electrodes, and a plurality of second electrodes on the plurality of emissive layers,
wherein the at least one pixel unit includes a power electrode pad connected to each of the plurality of second electrodes in the plurality of micro-LEDs, and
the power electrode pad is spaced from each of the plurality of first electrodes by a distance greater than an interelectrode distance between adjacent first electrodes of the plurality of first electrodes.

2. The micro-light-emitting diode mounting board according to claim 1, wherein
the at least one pixel unit includes a plurality of pixel units, and
the power electrode pad in one of the plurality of pixel units is spaced, by a distance greater than the interelectrode distance, from a first electrode in a micro-LED closest to the power electrode pad in the one pixel unit, of the plurality of micro-LEDs included in another of the plurality of pixel units adjacent to the one first pixel unit.

3. The micro-light-emitting diode mounting board according to claim 1 or claim 2, wherein
the power electrode pad has a shape different from a shape of each of the plurality of first electrodes.

4. The micro-light-emitting diode mounting board according to any one of claims 1 to 3, wherein
the power electrode pad has an area different from an area of each of the plurality of first electrodes as viewed in plan.

5. The micro-light-emitting diode mounting board according to claim 4, wherein
the power electrode pad has a larger area than each of the plurality of first electrodes as viewed in plan.

6. The micro-light-emitting diode mounting board according to any one of claims 1 to 5, wherein
the power electrode pad has a light reflectance different from a light reflectance of each of the plurality of first electrodes.

7. The micro-light-emitting diode mounting board according to any one of claims 1 to 6, wherein
the power electrode pad is more optically sensible than each of the plurality of first electrodes in an invisible light region.

8. The micro-light-emitting diode mounting board according to any one of claims 1 to 7, wherein
the power electrode pad is usable as an alignment mark to position the plurality of emissive layers on the plurality of first electrodes.

9. A micro-light-emitting diode mounting board, comprising:
a substrate having a mount surface receiving a plurality of micro-LEDs, the micro-LEDs being micro-light-emitting diodes; and
a plurality of pixel units on the mount surface, each of the plurality of pixel units including the plurality of micro-LEDs having different emission colors to operate as a basic element of display, the plurality of micro-LEDs including a plurality of first electrodes on the mount surface, a plurality of emissive layers on the plurality of first electrodes, and a plurality of second electrodes on the plurality of emissive layers,
wherein the plurality of pixel units include a first pixel unit including a power electrode pad connected to each of the plurality of second electrodes in the plurality of micro-LEDs and a second pixel unit adjacent to the first pixel unit and free of the power electrode pad, and
the power electrode pad is spaced from each of the plurality of first electrodes in the first pixel unit by a distance greater than an interelectrode distance between adjacent first electrodes of the plurality of first electrodes in the first pixel unit, and the power electrode pad is spaced, by a distance greater than an interelectrode distance between adjacent first electrodes of the plurality of first electrodes in the second pixel unit, from a first electrode in a micro-LED closest to the power electrode pad of the plurality of micro-LEDs included in the second pixel unit.

10. A display device, comprising:
the micro-light-emitting diode mounting board according to any one of claims 1 to 9,
wherein the substrate has an opposite surface opposite to the mount surface, and a side surface,
the micro-light-emitting diode mounting board includes side wiring on the side surface and a driver on the opposite surface,
the at least one pixel unit includes a plurality of pixel units arranged in a matrix, and
the plurality of micro-LEDs are connected to the driver with the side wiring.

11. A micro-light-emitting diode mounting board, comprising:
a substrate having a mount surface receiving a plurality of micro-LEDs, the micro-LEDs being micro-light-emitting diodes; and
at least one pixel unit on the mount surface, the at least one pixel unit including the plurality of micro-LEDs having different emission colors to operate as a basic element of display, the plurality of micro-LEDs including a plurality of first electrodes on the mount surface, a plurality of emissive layers on the plurality of first electrodes, and a plurality of second electrodes on the plurality of emissive layers,
wherein the at least one pixel unit includes a power electrode pad connected to each of the plurality of second electrodes in the plurality of micro-LEDs,
the power electrode pad is spaced from each of the plurality of first electrodes by a distance greater than an interelectrode distance between adjacent first electrodes of the plurality of first electrodes, and
the power electrode pad is less optically sensible than each of the plurality of second electrodes in a visible light region.

12. The micro-light-emitting diode mounting board according to claim 11, further comprising:
a light absorber on the power electrode pad.

13. A micro-light-emitting diode mounting board, comprising:
a substrate having a mount surface receiving a plurality of micro-LEDs, the micro-LEDs being micro-light-emitting diodes; and
at least one pixel unit on the mount surface, the at least one pixel unit including the plurality of micro-LEDs to operate as a basic element of display, the plurality of micro-LEDs including a plurality of first electrodes on the mount surface, a plurality of emissive layers on the plurality of first electrodes, and a plurality of second electrodes on the plurality of emissive layers,
wherein the at least one pixel unit includes a power electrode pad connected to each of the plurality of second electrodes in the plurality of micro-LEDs, and
the power electrode pad is spaced from each of the plurality of first electrodes by a distance greater than an interelectrode distance between adjacent first electrodes of the plurality of first electrodes.

14. A micro-light-emitting diode mounting board, comprising:
a substrate having a mount surface receiving a plurality of micro-LEDs, the micro-LEDs being micro-light-emitting diodes; and
at least one pixel unit on the mount surface, the at least one pixel unit including the plurality of micro-LEDs having different emission colors to operate as a basic element of display, the plurality of micro-LEDs including a plurality of first electrodes on the mount surface, a plurality of emissive layers on the plurality of first electrodes, and a plurality of second electrodes on the plurality of emissive layers,
wherein the at least one pixel unit includes a power electrode pad connected to each of the plurality of second electrodes in the plurality of micro-LEDs, and
the power electrode pad is spaced from each of the plurality of first electrodes by a distance greater than or equal to an interelectrode distance between adjacent first electrodes of the plurality of first electrodes.
